# EUROPÄISCHE PATENTSCHRIFT

(11) **EP 1 361 034 B1**
(45) Veröffentlichungstag und Bekanntmachung des Hinweises auf die Patenterteilung: **13.09.2006**
(21) Anmeldenummer: 03010114.1
(22) Anmeldetag: 05.05.2003
(51) Int. Cl.: B29C 45/14, G06K 19/077

(54) **Chipkarte und Verfahren zu deren Herstellung**
Chip card and method of manufacturing a chip card
Carte à puce et son procédé de fabrication

(30) Priorität: 06.05.2002 DE 10220239
(43) Veröffentlichungstag der Anmeldung: 12.11.2003
(73) Patentinhaber: Sagem Orga GmbH, 33104 Paderborn (DE)
(72) Erfinder: Zander, Jörg, 23909 Ratzeburg (DE)

(56) Entgegenhaltungen:
- EP-A- 0 692 770
- WO-A-03/005296
- US-A- 5 319 522
- PATENT ABSTRACTS OF JAPAN vol. 1999, no. 12, 29. Oktober 1999 (1999-10-29) & JP 11 186304 A (SANYO ELECTRIC CO LTD), 9. Juli 1999 (1999-07-09)

## Beschreibung

Die Erfindung betrifft eine Chipkarte, welche einen im Spritzgussverfahren hergestellten Kunststoffkartenkörper mit mindestens einer im Kartenkörper eingebetteten Kunststofffolie aufweist, wobei auf mindestens einer der Flachseiten der Kunststofffolie vorstehend eine aus mindestens einer Leiterbahn bestehende Spule aufgebracht ist. Darüber hinaus betrifft die Erfindung ein Verfahren zur Herstellung einer Chipkarte im Spritzgussverfahren, wobei die Chipkarte einen Kunststoffkartenkörper mit mindestens einer im Kartenkörper eingebetteten Kunststofffolie aufweist und auf der mindestens einer der Flachseiten der Kunststofffolie vorstehend eine aus einer Leiterbahn bestehende Spule aufgebracht ist.

Chipkarten der oben geschilderten gattungsgemäßen Art werden beispielsweise als Zugangsberechtigungskarten für abgesicherte Bereiche eingesetzt. Die auf den Chipkarten in Form eines Mikrochips vorhandenen Prozessorbausteine mit den in ihnen gespeicherten Daten kommunizieren dabei mit entsprechenden Lesegeräten kontaktlos, wobei der Informationsaustausch zwischen Chipkarte und Lesegerät über die innerhalb des Kartenkörpers der Chipkarte implantierte Spule erfolgt. Aus dem Stand der Technik sind darüber hinaus so genannte Dualinterfacekarten bekannt, bei denen neben dem kontaktlosen Datenaustausch mittels der angesprochenen Spulen zusätzlich auf den Chipkarten Kontaktfelder vorhanden sind, mit Hilfe derer eine kontaktbehaftete Kommunikation mit externen Lesegeräte vonstatten gehen kann.

Für die Herstellung derartiger gattungsgemäßer Chipkarten hat sich im Stand der Technik das so genannte "Inmold-Labeling"-Verfahren allgemein als vorteilhaft erwiesen. Das angesprochene gattungsgemäß zu den Spritzgussverfahren zählende Verfahren beinhaltet als wesentliche Verfahrenschritte, dass zunächst die zur Datenkommunikation notwendige Leiterbahnspule auf einer Kunststofffolie separat aufgebracht wird, was mittels eines Ätzprozesses oder eines Siebdruckvorganges vor sich gehen kann. Die aus einer oder mehreren Leiterbahnen bestehende Spule liegt dabei nach Beendigung des diesbezüglichen Herstellvorganges über die Oberfläche der Kunststofffolie vorstehend vor. Die mit der Spule versehene Kunststofffolie wird danach in ein zur Herstellung der Chipkarte vorgesehenes Spritzgusswerkzeug eingelegt, welches mit zwei Werkzeughälften und einer innerhalb der Werkzeughälften befindlichen, die Form der fertigen Chipkarte bildenden Werkzeugkavität versehen ist. Die beiden Werkzeughälften werden anschließend geschlossen und danach wird die innerhalb der geschlossenen Werkzeugform befindliche Kunststofffolie durch Zuführung eines verflüssigten Kunststoffes in die Kavität der Spritzgussform in einem so genannten Hinterspritzvorgang der Kunststoffkartenkörper der Chipkarte hergestellt.

Die verflüssigte Kunststoffmasse wird in die Kavität der Spritzgussform unter hohem Druck eingepresst. Dabei ergeben sich in unmittelbarer Nähe der Einpressöffnung für die Kunststoffschmelze hohe Geschwindigkeiten und hohe Druckkräfte. Auf Grund dieser Rahmenbedingungen besteht die Gefahr, dass die in unmittelbarer Nähe der Einpressöffnung befindlichen Leiterbahnen der Spule, die auf der Kunststofffolie vorstehend angeordnet sind, durch die entstehenden Scherkräfte beim Einpressen der Kunststoffschmelze in hohem Maße beansprucht und oftmals beschädigt werden. Die Funktion einer mit einer derart beschädigten Spule versehenen Chipkarte ist nicht mehr gegeben.

In der EP 0 692 770 A1 wird ein Verfahren und ein mit diesem Verfahren hergestellte Chipkarte beschrieben, bei dem zuerst ein Zwischenprodukt hergestellt wird, das aus einer leiterbahntragenden Kunststoffschicht und einer diese Schicht komplett überdeckende Schutzfolie besteht. In einer Ausführungsform wird die leiterbahntragende Schicht des Zwischenproduktes zwischen zwei thermoplastischen Folien, die die gleiche Größe wie die leiterbahntragende Schicht haben gehalten. Im folgenden Schritt wird das Zwischenprodukt in ein Spritzgußwerkzeug eingelegt und hinterspritzt. Alternativ hierzu wird ein Verfahren vorgestellt, bei dem die Lage der Einspritzöffnung des Spritzgußwerkzeuges geändert wird und dadurch nicht mehr der volle Einspritzdruck auf die Leiterbahn entfällt.

Aus der WO 03/005296 A1 ist ein Produkt bekannt, bei dem auch zuerst ein Zwischenprodukt aus einem Körper mit zu schützenden Komponenten und einer schützenden Zwischenlage hergestellt wird und dann das Endprodukt durch Hinterspritzen in einem Spritzgußwerkzeug hergestellt wird.

Aufgabe der vorliegenden Erfindung ist es daher, eine Chipkarte der eingangs geschilderten gattungsgemäßen Art bereitzustellen, bei der eine Beschädigung der empfindlichen Spulenleiterbahn(en) im Bereich der Einpressöffnung für die Kunststoffschmelze verhindert wird. Darüber hinaus besteht die Aufgabe der Erfindung darin, ein gattungsgemäßes Verfahren bereitzustellen, bei dem Chipkarten im Spritzgussverfahren hergestellt werden können, ohne dass eine Beschädigung der innerhalb der Chipkarten angeordneten Spule stattfindet. Darüber hinaus sollen die Chipkarte sowie das Verfahren kostengünstig herstellbar bzw. durchführbar sein.

Diese Aufgabe wird hinsichtlich der Chipkarte durch die im kennzeichnenden Teil des Anspruches 1 offenbarte technische Lehre gelöst. Wesentlich ist dabei, dass die Leiterbahn der Spule nur in dem Teilbereich der Kunststofffolie, welcher während des Spritzgussvorganges der Einspritzöffnung für die Kunststoffschmelze benachbart positioniert ist, mit einer Schutzfolie überdeckt ist. Auf diese Weise können die beim Einpressvorgang der Kunststoffschmelze auftretenden Scherbeanspruchungen an der innerhalb der Werkzeugkavität vorhandenen Oberflächen der Kunststofffolie die darauf befindlichen Leiterbahnen nicht direkt beaufschlagen und somit nicht beschädigen, da die empfindlichen Leiterbahnen in entsprechender Nähe der Einspritzöffnung vollständig abgedeckt sind.

Das erfindungsgemäße Verfahren zeichnet sich dabei dadurch aus, dass vor dem Einlegen der Kunststofffolie in die Werkzeugkavität nur in dem Teilbereich der Kunststofffolie, welchen während des Spritzgussvorganges den Einspritzöffnung (P) für die Kunststoffschmelze benach bart positioniert ist, die Leiterbahnspule mit der Schutzfolie bedeckt wird. Eingriffe an dem Spritzgusswerkzeug selber, die zu erhöhten Herstellkosten führen könnten, sind für die Herstellung der erfindungsgemäßen Chipkarte mit Hilfe des geschilderten Verfahrens überflüssig.

Wie angegeben in den Ansprüchen 1 und 2 lässt sich die Schutzfolie dabei mit unterschiedlichen Mitteln realisieren. Es hat sich für die Schutzfolie als vorteilhaft erwiesen, diese beispielsweise aus einem aufgespritzten Schutzlack herzustellen. Darüber hinaus besteht die Möglichkeit, dass die Schutzfolie aus einem Kunststoffmaterial besteht, welches an der der zu überdeckenden Leiterbahn zugewandten Seite mit einer Kleberschicht zur Fixierung an der Kunststofffolie bzw. über der Leiterbahn selbst versehen ist.

Eine weitere Realisierung des Schutzes der Leiterbahn besteht darin, die Schutzfolie aus dem Kunststoffmaterial des Kartenkörpers selbst auszubilden, wobei in einem dem eigentlichen Spritzgussprozess vorgeschalteten Arbeitsschritt auf die Kunststofffolie mit der darauf befindlichen Spule eine dünne Schicht des Kunststoffmaterials aufgebracht wird.

Schließlich besteht die Möglichkeit, die Schutzfolie aus einem einstückig an der Kunststofffolie festgelegten Folienstreifen zu formen, welcher vor dem Spritzgießvorgang über die auf der Kunststofffolie befindliche Leiterbahn umgelegt wird. Die letztgenannte Möglichkeit zeichnet sich insbesondere dadurch vorteilhaft aus, dass die als Trägermaterial der Spule dienende Kunststofffolie und die zusätzliche Schutzfolie in einem Arbeitsschritt hergestellt werden können, wobei das Umlegen auf Grund der geringen Dicke der Folie problemlos realisierbar ist.

Im Folgenden wird ein Ausführungsbeispiel des Gegenstandes der Erfindung anhand der beigefügten Zeichnungen näher erläutert.

Es zeigt:
- Figur 1: eine schematische vergrößerte Querschnittsdarstellung durch eine erfindungsgemäße Chipkarte,
- Figur 2A: eine Draufsicht auf die innerhalb der Chipkarte eingebettete Kunststofffolie mit der darauf angeordneten Spule vor dem Einlegen in das Spritzgusswerkzeug und
- Figur 2B: das Ausführungsbeispiel der Kunststofffolie aus Figur 2a vorbereitet für das Einlegen in die Werkzeugkavität der Spritzgussform.

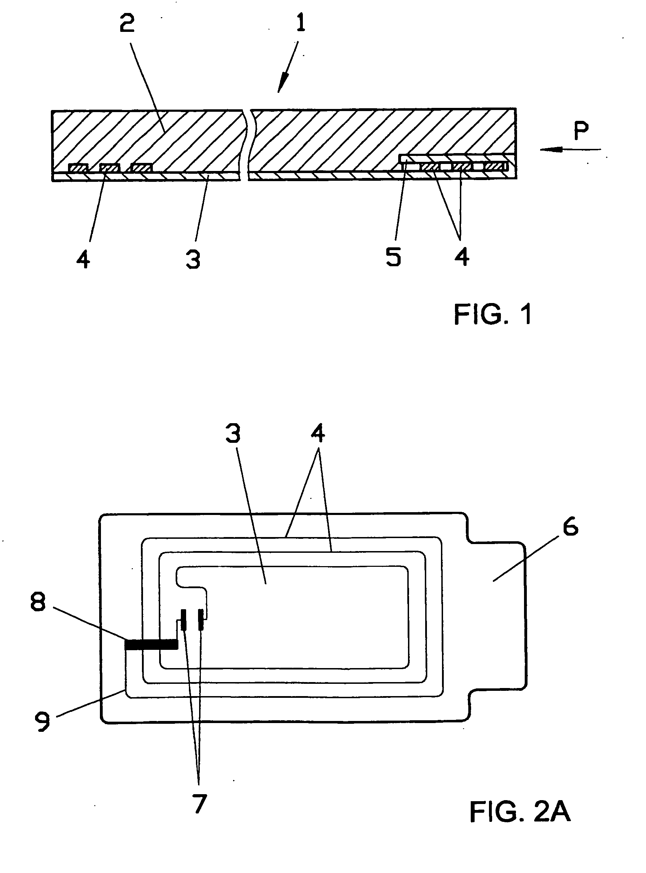

Die in der Figur 1 im Querschnitt dargestellte in ihrer Gesamtheit mit 1 bezeichnete Chipkarte besteht im Wesentlichen aus einem Kunststoffkartenkörper 2 und einer Kunststofffolie 3, welche auch als Spulenlabel bezeichnet wird. Auf der Kunststofffolie 3 sind in der Darstellung der Figur 1 mehrere Leiterbahnen 4 zu sehen, die in ihrer Gesamtheit eine Spule bilden, die zur kontaktlosen Datenübertragung zwischen der Chipkarte 1 und einer externen Lesevorrichtung dient. Einseitig sind die Leiterbahnen 4 mit einer Schutzfolie 5 abgedeckt. Die Schutzfolie 5 befindet sich über demjenigen Teilbereich der die Spule bildenden Leiterbahnen 4, welcher während des Spritzgussvorganges der Einspritzöffnung für die Kunststoffschmelze zur Herstellung des Chipkartenkörpers benachbart positioniert ist. Die Einspritzrichtung der verflüssigten Kunststoffschmelze ist in der Figur 1 durch den Pfeil P verdeutlicht.

Die Leiterbahnen 4 befinden sich, wie dies aus der Figur 1 ersichtlich ist, einseitig auf der Kunststofffolie 3 an dessen zum Innern des Chipkartenkörpers 2 gewandten Oberseite vorstehend. Durch die Abdeckung der Leiterbahnen 4 durch die Schutzfolie 5 können im Rahmen des Einspritzvorganges entstehende Scherkräfte nicht unmittelbar negativen Einfluss auf die Leiterbahnen 4 haben. Auf diese Weise wird eine Beschädigung der empfindlichen Spule im Bereich der Einspritzöffnung des Spritzgusswerkzeuges vermieden.

Die Schutzfolie 5 lässt sich beispielsweise durch einen aufgespritzten Schutzlack realisieren, darüber hinaus ist denkbar, die Schutzfolie aus einem Kunststoffmaterial herzustellen, welches an der der zu bedeckenden Leiterbahn zugewandten Seite mit einer Klebeschicht zur Fixierung an der Kunststofffolie 3 bzw. den Leiterbahnen 4 versehen ist.

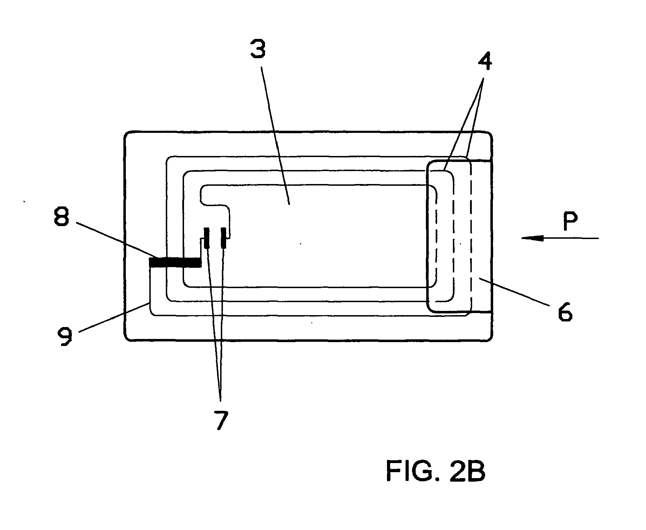

Eine weitere Realisierungsmöglichkeit der Schutzfolie 5 ist in der Darstellung der Figuren 2A und 2B verdeutlicht. Die angesprochenen Figuren zeigen jeweils eine Draufsicht auf die Kunststofffolie 3 mit den darauf angeordneten, die Spule bildenden Leiterbahnen 4. Die Leiterbahnen 4 bilden eine aus mehreren Windungen bestehende Spule, wobei die jeweiligen Spulenenden mit Kontaktflächen 7 versehen sind, an die ein in den Figuren nicht näher dargestelltes Chipmodul als Rechner und Speicherbaueinheit der Chipkarte anschließbar ist. Darüber hinaus ist die Spule mit einer Brücke 8 versehen, welche eine zu den darunter liegenden Leiterbahnen isolierende elektrische Verbindung der äußeren Spulenwicklung 9 zu einer der Kontaktflächen 7 herstellt. Die Kunststofffolie 3 besitzt prinzipiell den gleichen Grundriss wie die fertige Chipkarte 1, welche nach Einlegen der Kunststofffolie 3 in eine dafür vorgesehene Werkzeugkavität eines Spritzgusswerkzeuges durch Hinterspritzen der Kunststofffolie 3 hergestellt wird.

Wie aus der Figur 2A ersichtlich ist, besitzt die Kunststofffolie 3 einen seitlich über den eigentlichen Grundriss vorstehenden Folienstreifen 6. Dieser Folienstreifen 6 wird vor dem Einlegen der Kunststofffolie 3 erfindungsgemäß um ca. 180° über die auf der Kunststofffolie 3 befindlichen Leiterbahnen 4 umgelegt. Nach dem Umlegen des Folienstreifens 6 ergibt sich der eigentliche in der Figur 2B dargestellte Grundriss der Kunststofffolie 3, welcher der Größe des endgültigen Chipkartenkörpers entspricht. Der Folienstreifen deckt hierbei die Leiterbahnen 4 in demjenigen Teilbereich ab, welcher während des Spritzgussvorganges der Einspritzöffnung für die Kunststoffschmelze zur Herstellung des Chipkartenkörpers benachbart positioniert ist. Diese Einspritzöffnung ist durch den Pfeil P in der Darstellung der Figur 2B verdeutlicht.

Der Folienstreifen 6 kann beim Ausstanzen der Kunststofffolie gleichzeitig einstückig an dieser erhalten bleiben und kann anschließend mittels einer geeigneten mechanischen Vorrichtung so umgelegt werden, dass im Rahmen des Einspritzvorganges entstehende Scherkräfte nur mehr an der unbedenklichen Oberseite des die Schutzfolie 5 bildenden Folienstreifens 6 angreifen können. Auf diese Weise ist ein zuverlässiger Schutz der empfindlichen Leiterbahnen gewährleistet, ohne dass irgendwelche Änderungen am Spritzgießwerkzeug vorzunehmen sind. Die durch Umlegen des Folienstreifens 6 vorbereitete Kunststofffolie 3 wird danach in die Werkzeugkavität des Spritzgusswerkzeuges eingelegt. Dieses Spritzgusswerkzeug besteht in der Regel aus zwei Werkzeughälften, wobei in jeder Werkzeughälfte eine Teilvertiefung vorgesehen ist, auf dem Boden einer dieser Vertiefungen wird die Kunststofffolie 3 platziert, anschließend werden die beiden Werkzeughälften der Spritzgussform geschlossen und es wird der für die Herstellung des Kunststoffkartenkörpers notwendige verflüssigte Kunststoff in die Kavität der Spritzgussform eingepresst.

### Bezugszeichenliste

- 1: Chipkarte
- 2: Kartenkörper
- 3: Kunststofffolie
- 4: Leiterbahn
- 5: Schutzfolie
- 6: Folienstreifen
- 7: Kontaktfläche
- 8: Brücke
- 9: Spulenwicklung

## Patentansprüche

1. Chipkarte (1), welche einen im Spritzgussverfahren hergestellten Kunststoffkartenkörper (2) und mindestens eine im Kartenkörper eingebettete Kunststoffolie (3) aufweist, wobei auf mindestens einer der Flachseiten der Kunststoffolie (3) vorstehend eine aus mindestens einer Leiterbahn (4) bestehende Spule aufgebracht ist und wobei die Leiterbahn (4) der Spule, mit einer Schutzfolie (5) überdeckt ist,
**dadurch gekennzeichnet, dass**
- die Schutzfolie (5) nur den Teilbereich der Kunststoffolie (3) überdeckt, der während der Herstellung im Spritzgussverfahren der Einspritzöffnung (P) für die Kunststoffschmelze benachbart positioniert war, und entweder
- die Schutzfolie (5) aus einem Schutzlack besteht oder
- die Schutzfolie (5) aus einem Kunststoffmaterial besteht, welches an der, der Leiterbahn (4) zugewandten, Seite mit einer Kleberschicht versehen ist, oder
- die Schutzfolie (5) aus dem Kunststoffmaterial des Kartenkörpers besteht oder
- die Schutzfolie (5) aus einem einstückig an der Kunststoffolie (3) festgelegten Folienstreifen (6) besteht.

2. Spritzgussverfahren zur Herstellung einer Chipkarte (1), welche einen Kunststoffkartenkörper (2) und mindestens eine im Kartenkörper eingebettete Kunststoffolie (3) aufweist, wobei auf mindestens einer der Flachseiten der Kunststoffolie (3) vorstehend eine aus mindestens einer Leiterbahn bestehende Spule aufgebracht ist und wobei die Leiterbahn (4) der Spule, mit einer Schutzfolie (5) überdeckt ist, bei der nacheinander folgende Verfahrensschritte durchgeführt werden:
- Aufbringen der Leiterbahnspule auf die Kunststoffolie (3),
- Einlegen der vorbereiteten Kunststoffolie (3) in ein zur Herstellung der Chipkarte (1) vorgesehenes Spritzgusswerkzeug, welches mit zwei Werkzeughälften und einer innerhalb der Werkzeughälften befindlichen die Form der fertigen Chipkarten bildenden Werkzeugkavität versehen ist,
- Schließen der beiden Werkzeughälften der Spritzgussform, Zuführung eines verflüssigten Kunststoffes in die Kavität der Spritzgussform zur Bildung des Kartenkörpers (2),
**dadurch gekennzeichnet, dass**
- die Leiterbahn (4) der Spule vor dem Einbringen der Kunststoffolie (3) in das Spritzgusswerkzeug nur in dem Teilbereich der Kunststoffolie (3), welcher während des Spritzgussvorganges der Einspritzöffnung (P) für die Kunststoffschmelze benachbart positioniert ist,
mit einer Schutzfolie (5) bedeckt wird,
und entweder
- die Kunststoffolie (3) mit einem über ihren in Chipkartengröße ausgebildeten Querschnitt vorstehenden Folienstreifen (6) versehen wird, welcher vor dem Einlegen in die Werkzeugkavität über die auf der Kunststoffolie (3) vorhandenen benachbarten Leiterbahnen (4) gefaltet wird, oder
- die Kunststoffolie (3) im Bereich der Einspritzöffnung für die Kunststoffschmelze beim anschließenden Spritzgussvorgang mit einer aus dem Kunststoffmaterial des Kartenkörpers (2) bestehenden Überzug beschichtet wird, oder
- die Kunststoffolie (3) in dem Teilbereich, welcher während des Spritzgussvorganges der Einspritzöffnung für die Kunststoffschmelze benachbart positioniert ist mit einem Schutzlack beschichtet wird.

## Claims

1. Smart card (1) having a plastic card body (2) produced using an injection molding technique and at least one plastic film (3) embedded in the card body, in which a coil consisting of at least one conductor track (4) is applied protuberantly to at least one of the flat sides of the plastic film (3), and in which the conductor track (4) of the coil is covered by a protective film (5),
**characterized in that**
- the protective film (5) covers only the partial area of the plastic film (3) that was positioned adjacent to the injection aperture (P) for the molten plastic during production using an injection molding technique, and either
- the protective film (5) consists of a protective lacquer, or
- the protective film (5) consists of a plastic material which is provided with an adhesive layer on the side facing the conductor track (4), or
- the protective film (5) consists of the plastic material of the card body, or
- the protective film (5) consists of a strip of film (6) affixed in one piece to the plastic film (3).

2. Injection molding technique for producing a smart card (1) having a plastic card body (2) and at least one plastic film (3) embedded in the card body, in which a coil consisting of at least one conductor track is applied protuberantly to at least one of the flat sides of the plastic film (3), and in which the conductor track (4) of the coil is covered by a protective film (5), during which the following process steps are performed:
- application of the conductor track coil onto the plastic film (3),
- insertion of the prepared plastic film (3) into an injection molding tool provided for producing the smart card (1), which tool is provided with two tool halves and a tool cavity forming the shape of the finished smart cards situated within the tool halves,
- closure of the two tool halves of the injection mold, introduction of a liquefied plastic into the cavity of the injection mold in order to form the card body (2),
**characterized in that**
- prior to the introduction of the plastic film (3) into the injection molding tool, the conductor track (4) of the coil is covered by a protective film (5) only in the partial area of the plastic film (3) that is positioned adjacent to the injection aperture (P) for the molten plastic during the injection molding operation, and either
- the plastic film (3) is provided with a strip of film (6) that protrudes beyond its cross-section of the size of the smart card, which strip of film is folded over the adjacent conductor tracks (4) present on the plastic film (3) prior to insertion into the tool cavity, or
- in the area of the injection aperture for the molten plastic, the plastic film (3) is covered by a coating consisting of the plastic material of the card body (2) during the subsequent injection molding operation, or
- the plastic film (3) is coated with a protective lacquer in the partial area that is positioned adjacent to the injection aperture for the molten plastic during the injection molding operation.

## Revendications

1. Carte à puce (1), qui présente un corps de carte (2) en matière synthétique, fabriqué selon le procédé de moulage par injection, et au moins une feuille en matière synthétique (3) encastrée dans ledit corps de carte, une bobine, qui consiste en au moins une piste conductrice (4), étant appliquée, en saillie, sur au moins l'une des faces plates de la feuille de matière synthétique (3), et la piste conductrice (4) de ladite bobine étant recouverte par une feuille protectrice (5),
**caractérisée en ce que**
- la feuille protectrice (5) ne recouvre que la zone partielle de la feuille en matière synthétique (3) qui, pendant la fabrication selon le procédé de moulage par injection, était positionnée dans le voisinage de l'ouverture d'injection (P) de la matière synthétique en fonte, et ou bien
- la feuille protectrice (5) consiste en une laque protectrice, ou
- la feuille protectrice (5) consiste en une matière synthétique qui est pourvue d'une couche de colle sur le côté orienté ver la piste conductrice (4), ou
- la feuille protectrice (5) consiste en la matière synthétique du corps de carte, ou la feuille protectrice (5) consiste en un ruban de film (6) qui est fixée d'une pièce à la feuille en matière synthétique (3).

2. Procédé de moulage par injection pour la fabrication d'une carte à puce (1), qui présente un corps de carte (2) en matière synthétique et au moins une feuille en matière synthétique (3) encastrée dans ledit corps de carte, une bobine, qui consiste en au moins une piste conductrice (4), étant appliquée, en saillie, sur au moins l'une des faces plates de la feuille en matière synthétique (3), et la piste conductrice (4) de ladite bobine étant recouverte par une feuille protectrice (5), lors duquel les étapes suivantes sont exécutées successivement:
- Application de la bobine à piste conductrice sur la feuille en matière synthétique (3)
- Mise de place de la feuille en matière synthétique (3) préparée dans un outil de moulage par injection prévu pour la fabrication de ladite carte à puce (1), lequel est composé de deux moitiés de moule et d'un cavité qui, disposée à l'intérieur des moitiés de moule, confère sa forme à la carte à puce finie.
- Fermeture des deux moitiés de l'outil de moulage par injection, apport d'une matière synthétique liquéfiée dans la cavité de l'outil de moulage par injection pour former le corps de carte (2),
**caractérisé en ce que**,
- avant l'insertion de la feuille de matière synthétique (3) dans l'outil de moulage par injection, la piste conductrice (4) de la bobine est recouverte avec une feuille protectrice (5) seulement dans la zone partielle qui, pendant le processus de moulage par injection, est positionnée dans le voisinage de l'ouverture d'injection (P) de la matière synthétique en fonte, et ou bien
- la feuille en matière synthétique (3) est pourvue d'un ruban de film (6) en saillie au-delà de sa section transversale de la grandeur de la carte à puce, lequel est plié sur les pistes conductrices (4), présentes sur la feuille en matière synthétique (3), avant l'introduction dans la cavité de l'outil, ou
- la feuille de matière synthétique (3), dans la zone de l'ouverture d'injection de la matière synthétique en fonte, lors de l'opération de moulage par injection suivante, est pourvu d'un revêtement qui consiste en la matière synthétique du corps de carte (2), ou
- la feuille de matière synthétique (3) est revêtue d'une laque protectrice, dans la zone partielle qui, pendant le processus de moulage par injection, est positionnée dans le voisinage de l'ouverture d'injection de la matière synthétique en fonte.
